# EUROPÄISCHE PATENTSCHRIFT

(11) **EP 0 542 768 B1**
(45) Veröffentlichungstag und Bekanntmachung des Hinweises auf die Patenterteilung: **09.07.1997**
(21) Anmeldenummer: 91912995.7
(22) Anmeldetag: 25.07.1991
(51) Int. Cl.: G03F 7/00, G03F 7/26

(54) **VERFAHREN ZUR HERSTELLUNG VON MIKROSTRUKTUREN MIT BEISPIELSWEISE UNTERSCHIEDLICHER STRUKTURHÖHE**
PROCESS FOR PRODUCING MICROSTRUCTURES WITH LOCALLY DIFFERENT STRUCTURAL HEIGHTS
PROCEDE DE REALISATION DE MICROSTRUCTURES CARACTERISEES PAR EXEMPLE PAR DES HAUTEURS DIFFERENTES

(30) Priorität: 31.07.1990 DE 4024275
(43) Veröffentlichungstag der Anmeldung: 26.05.1993
(73) Patentinhaber: Forschungszentrum Karlsruhe GmbH, 76133 Karlsruhe (DE); Bürkert GmbH, D-74653 Ingelfingen (DE)
(72) Erfinder: KOWANZ, Bernd, D-7515 Linkenheim (DE); BACHER, Walter Dr., D-7513 Stutensee 4 (DE); BLEY, Peter, Dr., D-7514 Eggenstein-Leopoldshafen (DE); HARMENING, Michael, Dr., D-7513 Stutensee-Büchig (DE); MOHR, Jürgen, Dr., D-7511 Sulzfeld (DE)
(74) Vertreter: Rückert, Friedrich, Dr.
(86) Internationale Anmeldenummer: DE9100602
(87) Internationale Veröffentlichungsnummer: WO9202858

(56) Entgegenhaltungen:
- WO-A-89/01632
- US-A- 4 349 621

## Beschreibung

Die Erfindung betrifft ein Verfahren zur Herstellung von Mikrostrukturen mit bereichsweise unterschiedlicher Strukturhöhe gemäß dem Oberbegriff des ersten Patentanspruchs.

Ein solches Verfahren ist aus der DE-PS 36 23 637 bekannt. Bei diesem Verfahren wird eine Schicht eines Positiv-Resistmaterials mit Röntgenlicht partiell bestrahlt, wobei eine Röntgenmaske verwendet wird, die zusätzlich zu einer strukturierten Absorberschicht, die Synchrotronstrahlung weitgehend vollständig absorbiert, mindestens eine weitere strukturierte Absorberschicht trägt, die Synchrotronstrahlung bevorzugt nur in einem Teil des Spektrums absorbiert.

Als Positiv-Resistmaterial wird ein Polymer mit scharfer unterer Grenzdosis verwendet.

In den Bereichen, die nicht durch die strukturierte Absorberschicht abgeschattet werden, erhält der Resist bei der Bestrahlung entlang seiner gesamten Dicke eine Dosis, die höher ist als die untere Grenzdosis des Resistmaterials. In den Bereichen, die durch die strukturierte Absorberschicht abgeschattet werden, erhält der Resist bei der Bestrahlung entlang seiner ganzen Dicke eine Dosis unterhalb der Grenzdosis des Resistmaterials. In den Bereichen, die durch die strukturierte, teilweise absorbierende Absorberschicht abgeschattet werden, wird bei der Bestrahlung nur im oberen Teil des Resists eine Dosis abgelagert, die größer als die untere Grenzdosis des Resistmaterials ist; der untere Teil erhält eine geringere Dosis.

Da der Resist nur an den Stellen löslich wird, die von einer Dosis oberhalb der unteren Grenzdosis getroffen sind, werden Mikrostrukturen mit bereichsweise unterschiedlicher Strukturhöhe erhalten.

Dieses Verfahren erfordert einen Resist, der eine genau definierte Grenzdosis aufweist. Zum anderen müssen die Absorbereigenschaften der Röntgenmaske sorgfältig auf das Resistmaterial eingestellt werden.

Die DE-PS 34 40 110 beschreibt ein anderes Verfahren der eingangs genannten Art für den speziellen Fall säulenförmiger Strukturen mit einem dünnen, längeren und einem dickeren, kurzen Abschnitt.

Dabei wird eine Resistplatte von ca. 0,5 mm Dicke über eine Röntgenmaske mit energiereicher Röntgenstrahlung eines Synchrotrons partiell durchstrahlt in der Weise, daß zylindrische Bereiche mit einem Durchmesser von ca. 30 µm in einem vorgegeben Rasterabstand r entstehen, deren Löslichkeit gegenüber den unbestrahlten Bereichen der Resistplatte stark erhöht ist. Sodann erfolgt eine weitere partielle Bestrahlung der Resistplatte von einer Seite her im selben Raster r, wobei die Eindringtiefe der Strahlung jedoch geringer ist als die Resistplattenstärke und der Durchmesser der bestrahlten Bereiche ca. 70 µm beträgt, so daß ein dickerer und kürzerer zylindrischer bestrahlter Bereich entsteht. Die derart bestrahlten und löslich gemachten Bereiche werden mit einem beispielsweise in der De-OS 30 39 110 beschriebenen flüssigen Entwickler entfernt. Dadurch entsteht eine Form mit säulenförmigen Strukturen, die einen dünneren und einen dickeren Abschnitt aufweisen.

Dieses Verfahren läßt sich prinzipiell auf die Herstellung von Mikrostrukturen mit anderen lateralen Konturen und auch mit mehr als zwei unterschiedlichen Strukturhöhen übertragen.

Ein grundsätzliches Problem bei den beiden genannten Verfahren besteht darin, daß bei den derzeit bekannten Resistsystemen bei Dosisablagerungen unterhalb der Grenzdosis zwar beim Entwickeln kein Abtrag mehr erfolgt, die mechanischen Eigenschaften und die Lösungsmittelbeständigkeit dieser Bereiche jedoch deutlich schlechter sind. Die Höhe der Strukturen läßt sich nicht mit ausreichender Genauigkeit vorgeben, weil die Schwächung der Strahlung und damit die abgelagerte Dosis mit zunehmender Eindringtiefe nur schwer vorherbestimmbar ist.

Der Erfindung liegt die Aufgabe zugrunde, ein Verfahren zur Herstellung von gestuften Mikrostrukturen der eingangs genannten Art vorzuschlagen, bei dem die Nachteile der bekannten Verfahren vermieden werden. Das Verfahren soll Toleranzen der Stufenhöhe im Mikrometer-Bereich ermöglichen. Darüber hinaus soll eine hohe Lösungsmittelbeständigkeit und gute mechanische Eigenschaften der Mikrostrukturen erzielt werden.

Die Aufgabe wird erfindungsgemäß durch die im Kennzeichen des ersten Patentanspruchs beschriebene Maßnahme gelöst.

Die Unteransprüche geben vorteilhafte Ausführungsformen und Weiterbildungen des erfindungsgemäßen Verfahrens an.

Das erfindungsgemäße Verfahren wird beispielhaft anhand der Figuren 1 bis 10 beschrieben.

Die Figuren 1 bis 4 zeigen drei verschiedene Verfahrensvarianten, mit denen die Schicht eines Resistmaterials mit Mikrostrukturen versehen werden kann.

Die Figuren 5 bis 7 zeigen die Herstellung von Mikrostrukturen mit bereichsweise unterschiedlicher Strukturhöhe.

Die Figur 8 bis 10 illustrieren die Möglichkeiten der Weiterverarbeitung der nach dem erfindungsgemäßen Verfahren hergestellten Mikrostrukturen.

Wie erwähnt, kann die Schicht eines Resistmaterials nach drei verschiedenen Verfahrensvarianten mit Mikrostrukturen versehen werden.

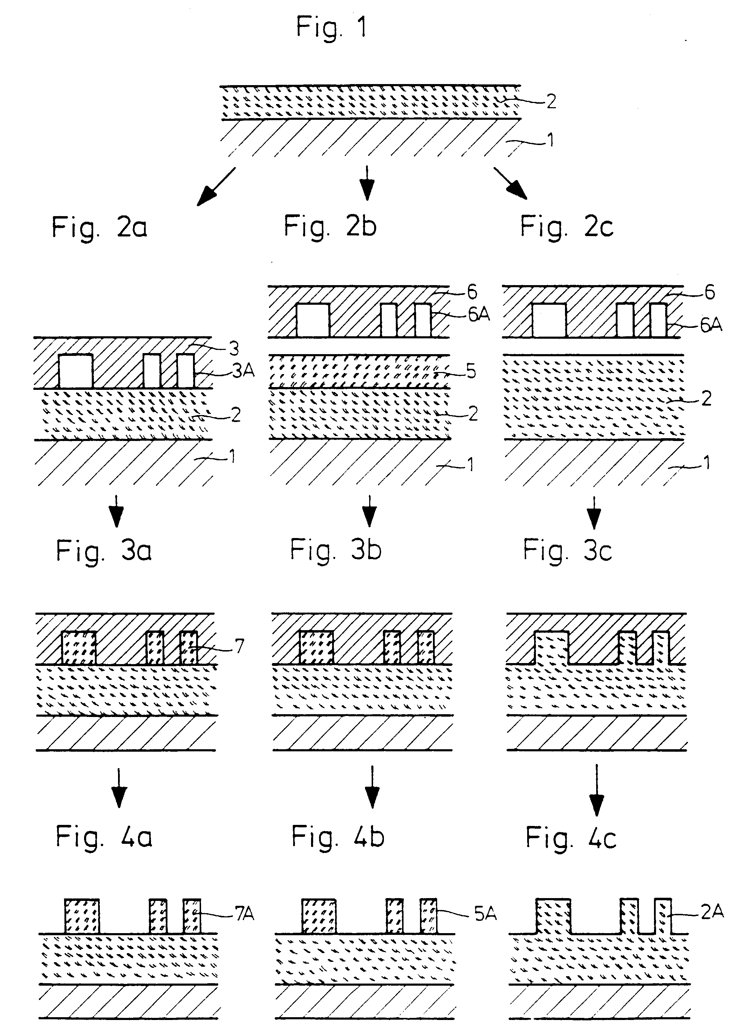

Die erste Variante ist in den Figuren 1, 2a, 3a und 4a dargestellt.

Auf die Resistschicht 2, die mit einer Grundplatte 1 verbunden ist, wird mit Hilfe eines Mikroabformwerkzeugs 3 eine Kunststoffmikrostruktur im Reaktions- oder Spritzguß abgeformt. Im Abformprozeß werden hierzu die Formnester 3A des Abformwerkzeugs mit Reaktionsharz- oder Formmasse befüllt. Der befüllte Formeinsatz wird anschließend entsprechend Fig. 3a auf die Resistschicht aufgepreßt. Im Verlauf der Prozeßführung, d. h. während der Aushärtung oder der Verfestigung des Kunststoffes, wird eine haftfeste Verbindung zwischen dem Kunststoff der Mikrostrukturen und der Resistschicht aufgebaut. Durch eine Trennbewegung von Abformwerkzeug und Grundplatte werden die Mikrostrukturen entformt. Man erhält so eine Resistschicht, auf der Mikrostrukturen aus Kunststoff mit definierter Strukturhöhe angeordnet sind (Fig. 4a). Da sichergestellt werden kann, daß die Abformmasse 7 der Mikrostrukturen nicht in die Verbindungsebene zwischen Resist und Kunststoff eindringt, muß der strukturierte Kunststoff 7a nicht notwendigerweise Resisteigenschaften besitzen.

Die zweite Variante ist in den Figuren 1, 2b, 3b und 4b dargestellt.

Diese Variante zur Herstellung von Mikrostrukturen auf der Oberfläche einer Resistschicht besteht darin, daß auf die Resistschicht 2 eine weitere Schicht 5 mit einer fest vorgegebenen Dicke von einigen Mikrometern bis mehrere hundert Mikrometer ganzflächig aufgebracht wird. Diese Schicht wird anschließend im Verlauf eines Abformprozesses durch ein Prägeverfahren (Fig. 3b) mit Hilfe eines Abformwerkzeugs 6 strukturiert. Das Volumen und damit die Dicke der prägbaren Schicht 5 muß hierbei an das Volumen der Formnester 6A angepaßt sein. Nach dem Verfestigen des Kunststoffs werden die Mikrostrukturen durch eine Trennbewegung von Abformwerkzeug 6 und Grundplatte 1 entformt. Man erhält auf diese Weise eine Resistschicht, auf der Mikrostrukturen aus Kunststoff mit definierter Strukturhöhe angeordnet sind (Fig. 4b).

Die zweite Variante wird vorzugsweise dann gewählt, wenn die zu prägende Schicht 5 keine Resisteigenschaften aufweist oder der Resist 2 durch Prägen nicht strukturiert werden kann.

Die dritte Variante ist in den Figuren 1, 2c, 3c und 4c dargestellt.

Kann die Schicht 2 durch Prägen strukturiert werden und verfügt sie über ausreichende Resisteigenschaften, so kann auf die Schicht 5 nach Variante 2 verzichtet werden.

In diesem Fall wird die Schicht 2 entsprechend dicker gewählt und direkt mit Hilfe des Abformwerkzeugs 6 mit Formnestern 6A geprägt.

Vorzugsweise wird eine geeignete Grundplatte 1 verwendet.

Die Herstellung der Mikrostrukturen auf dem Resist durch Prägen (Variante 2 und 3) hat gegenüber dem Reaktions- oder Spritzgußverfahren nach Variante 1 den Vorteil, daß dabei gleichzeitig je nach Notwendigkeit zusätzlich eine elektrisch leitfähige Deckschicht auf den Stirnflächen der Mikrostrukturen angebracht werden kann. Die Einzelheiten dieses besonders vorteilhaften Prägeverfahrens können der Patentanmeldung P 40 10 669.1 entnommen werden.

Eine solche leitfähige Deckschicht verbessert insbesondere das Abformergebnis bei einer nachfolgenden galvanischen Metallabscheidung.

Nach Entformen des Abform- oder Prägewerkzeugs liegt nach allen drei Verfahrensvarianten eine Probe vor, bei der Mikrostrukturen 2A, 5A, 7A auf einer durchgehenden Resistschicht angeordnet sind. Diese Resistschicht ist dabei vorzugsweise mit einer Grundplatte 1 verbunden.

Das Verfahren zur Herstellung der Mikrostrukturen mit bereichsweise unterschiedlicher Strukturhöhe wird anhand der nach Variante 3 erhaltenen, geprägten Resistschicht entsprechend Fig. 4c erläutert.

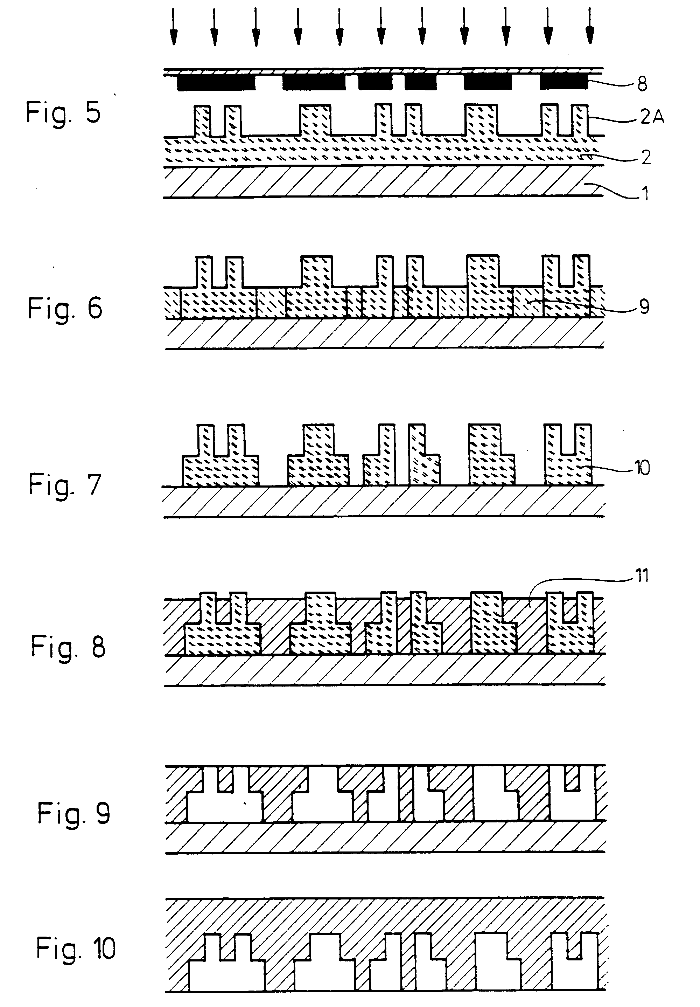

Gemäß Fig. 5 wird die durch Prägen strukturierte Probe, die auf einer Grundplatte 1 das Resistmaterial 2 mit den Mikrostrukturen 2A aufweist, durch eine Maske mit senkrecht einfallender Synchrotronstrahlung nahezu bestrahlt. Die Maske enthält Bereiche 8, durch die die Synchrotronscrahlung nahezu völlig absorbiert wird.

Die Maske mit den strahlenundurchlässigen Bereichen 8 wird nunmehr oberhalb der Strukturen 2A entsprechend den gewünschten Stufenformen ausgerichtet.

Bestehen die Strukturen 2A nicht aus Resistmaterial, z. B. wenn sie nach Variante 1 hergestellt wurden, können die Strukturen 2A durch die Bereiche 8 abgeschattet werden.

Bestehen die Strukturen 2A jedoch aus Resistmaterial z. B. durch Herstellung nach Variante 3, kann durch geeignete Anordnung der Maskenbereiche 8 auch die Form der Strukturen 2A verändert werden. Auf diese Weise können auch nachträglich noch die mit einem vorhandenen Prägewerkzeug 6 erzeugten Strukturen verändert werden, womit sich eine von der Juszierung unabhängige gleichmäßige Form über die gesamte Strukturhöhe erzielen läßt.

Die Teile 9 des Resistmaterials 2 bzw. 2A, die nicht durch die Maskenbereiche 8 abgeschattet werden, werden nun von Röntgenoder Synchrotronstrahlung durchstrahlt (Fig. 6) und dabei strahlenchemisch verändert.

Diese Bereiche 9 können in einem geeigneten Lösungsmittel entfernt werden. Nach diesem Prozeßschritt liegen somit gestufte Mikrostrukturen 10 in Kunststoff vor, deren Stufenhöhe genau durch die Dicke der resisttauglichen Schicht definiert ist (Fig. 7). Die Höhe der Strukturen auf dem lithographisch erzeugten Sockel wird durch die Tiefe der Formnester im Abformwerkzeug vorgegeben.

Wird die so erzeugte Kunststoffstruktur z. B. galvanisch mit Metall 11 gefüllt (Fig. 8) und die Resiststruktur nach dem Galvanikschritt weggelöst, ergibt sich eine stufenförmige Metallstruktur (Fig. 9). Verbleiben die erzeugten Metallstrukturen auf der Grundplatte, so lassen sich nach dem erfindungsgemäßen Verfahren überhängende oder aber auch Strukturen in Brückenform herstellen.

Durch Übergalvanisieren der gestuften Resiststrukturen (Fig. 8) können darüber hinaus gestufte Abformwerkzeuge gefertigt werden (Fig. 10), mit denen die beschriebenen Schritte erneut durchgeführt werden können. Man erhält dann nicht nur zweistufige, sondern nach n-maligem Durchführen des erfindungsgemäßen Verfahrens n-stufige Strukturen.

Die technischen Einzelheiten der Verfahrensschritte Röntgenlithographie und Abformung können den beiden KfK-Berichten Nr. 3995 "Herstellung von Mikrostrukturen und großem Aspektverhältnis und großer Strukturhöhe mit Synchrotronstrahlung, Galvanoformung und Kunststoffabformung (LIGA-Verfahren) von E. W.

Becker, W. Ehrfeld, P. Hagmann, A. Maner, D. Munchmeyer, Kernforschungszentrum Karlsruhe, November 1985 sowie Nr. 4267 "Untersuchungen zur Herstellung von galvanisierbaren Mikrostrukturen mit extremer Strukturhöhe durch Abformen mit Kunststoff im Reaktionsgießverfahren", Kernforschungszentrum Karlsruhe, Mai 1987, entnommen werden.

Mit dem erfindungsgemäßen Verfahren lassen sich mehrfach gestufte Mikrostrukturen mit Strukturhöhen von mehreren hundert Mikrometern bei lateralen Abmessungen im Mikrometerbereich und Stufenhöhen von wenigen Mikrometern bis mehrere hundert Mikrometer erzeugen. Ein wesentlicher Vorzug des erfindungsgemäßen Verfahrens ist, daß die Toleranzen der Stufenhöhe im Mikrometerbereich liegen, somit wesentlich kleiner sind als die der bekannten Verfahren.

Durch die Grundplatte 1 (Fig. 1 bis 9) wird die Resistschicht im Bedarfsfall mechanisch verstärkt, so daß die verschiedenen erfindungsgemäßen Verfahrensschritte mit größerer Präzision durchgeführt werden können. Nach der Fertigstellung der mikrostrukturierten Körper wird sie in diesem Fall abgetrennt. Vorzugsweise ist die Grundplatte mit der Resistschicht fest verbunden. Die Grundplatte kann jedoch auch Teil der herzustellenden mikrostrukturierten Körper werden.

Bei der Wahl der Grundplatte wird man den vorgesehenen Verwendungszweck der gestuften Mikrostrukturen berücksichtigen. Außer einem Metall kommen auch die Materialien Keramik oder ein Halbleitermaterial in Frage. Die Grundplatte kann jedoch auch aus einem Kunststoff bestehen.

Beispiele für bevorzugte Anwendungsgebiete der erfindungsgemäß hergestellten Mikrostrukturen sind Ventilplatten zur Herstellung von Mikroventilen, kapazitive Beschleunigungssensoren, die bezüglich des Platzbedarfs optimiert sind sowie Zahnräder oder Zahnstangen mit zwei unterschiedlichen, übereinander liegenden Zahnkränzen für die Herstellung von Mikrogetrieben.

## Patentansprüche

1. Verfahren zur Herstellung von gestuften Mikrostrukturen mit bereichsweise unterschiedlicher Strukturhöhe, bei dem
a) eine Schicht eines gegenüber Röntgenstrahlung empfindlichen Positiv-Resistmaterials unter Verwendung einer Maske mit Röntgenstrahlung bestrahlt wird,
b) die bestrahlten Bereiche mit Hilfe eines Entwicklers entfernt werden,
dadurch gekennzeichnet, daß
c) die Schicht des Resistmaterials vor Durchführung der Schritte a) und b) auf ihrer der Strahlung zugewandten Seite mit Mikrostrukturen versehen wird.

2. Verfahren nach Anspruch 1, dadurch gekennzeichnet, daß die Mikrostrukturen auf der Schicht des Resistmaterials erzeugt werden durch
a) Auffüllen der Räume zwischen den Mikrostrukturen eines mikrostrukturierten Abformwerkzeugs mit einem fließfähigen, härtbaren Kunststoff,
b) Aufpressen des auf diese Weise befüllten Abformwerkzeugs auf die Schicht des Resistmaterials, so daß der Kunststoff zwischen den Mikrostrukturen des Abformwerkzeugs mit der Schicht des Resistmaterials in Kontakt kommt,
c) Aushärten des Kunststoffs im Abformwerkzeug unter Herstellung einer festen Verbindung zwischen dem Kunststoff und der Schicht des Resistmaterials,
d) Trennung des Abformwerkzeugs vom mikrostrukturierten Kunststoff und der Schicht des Resistmaterials.

3. Verfahren nach Anspruch 1, dadurch gekennzeichnet, daß die Mikrostrukturen auf der Schicht des Resistmaterials erzeugt werden durch
a) Herstellen einer festen Verbindung von einer Schicht eines prägbaren Kunststoffs mit der Schicht des Resistmaterials
b) Prägen der Schicht des Kunststoffs mit Hilfe eines Mikrostrukturen aufweisenden Abformwerkzeugs in der Weise, daß mindestens ein Teil der Mikrostruktur-Stirnflächen des Abformwerkzeugs die Schicht des Resistmaterials freilegt,
c) Trennung des Abformwerkzeugs von der mikrostrukturierten Schicht des Kunststoffs und der Schicht des Resistmaterials.

4. Verfahren nach Anspruch 1, dadurch gekennzeichnet, daß die Mikrostrukturen auf der Schicht des Resistmaterials erzeugt werden durch
a) Herstellen einer dicken, prägbaren Schicht des Resistmaterials, deren Dicke mindestens der Summe aus Höhe der Schicht des Resistmaterials und maximalen Höhe der hierauf herzustellenden Mikrostrukturen entspricht,
b) Prägen der dicken Schicht des Resistmaterials mit Hilfe eines Mikrostrukturen aufweisenden Abformwerkzeugs in der Weise, daß mindestens ein Teil der Mikrostruktur-Stirnflächen soweit in die dicke Schicht eindringen, daß über diesem Teil der Mikrostruktur-Stirnflächen die Schichtdicke des Resistmaterials erhalten wird,
c) Trennung des Abformwerkzeugs von der mikrostrukturierten dicken Schicht des Resistmaterials.

5. Verfahren nach einem der Ansprüche 1 bis 4, dadurch gekennzeichnet, das die Schicht des Resistmaterials auf der nicht mit Mikrostrukturen zu versehenden oder versehenen Seite mit einer Grundplatte verbunden wird.

6. Verfahren nach Anspruch 5, dadurch gekennzeichnet, daß die Grundplatte aus Metall oder Keramik oder Halbleitermaterial oder Kunststoff besteht.

## Claims

1. Method of producing stepped microstructures having structural heights which differ according to region, wherein
a) a layer of a positive resist material, which is sensitive to X-radiation, is irradiated with X-radiation using a mask,
b) the irradiated regions are removed by means of a developer,
characterised in that
c) the layer of resist material is provided with microstructures on its side facing the radiation prior to steps a) and b) being accomplished.

2. Method according to claim 1, characterised in that the microstructures are produced on the layer of resist material by
a) filling the spaces between the microstructures of a microstructured shaping tool with a flowable, hardenable plastics material,
b) pressing the shaping tool, which is filled in this manner, onto the layer of resist material, so that the plastics material between the microstructures of the shaping tool comes into contact with the layer of resist material,
c) hardening the plastics material in the shaping tool so as to establish a firm connection between the plastics material and the layer of resist material,
d) separating the shaping tool from the microstructured plastics material and the layer of resist material.

3. Method according to claim 1, characterised in that the microstructures are produced on the layer of resist material by
a) establishing a firm connection between a layer of an embossable plastics material and the layer of resist material,
b) stamping the layer of plastics material by means of a shaping tool, which has microstructures, in such a manner that at least a portion of the microstructure end faces of the shaping tool exposes the layer of resist material,
c) separating the shaping tool from the microstructured layer of plastics material and the layer of resist material.

4. Method according to claim 1, characterised in that the microstructures are produced on the layer of resist material by
a) producing a thick, stampable layer of resist material, the thickness of which corresponds to at least the sum of the height of the layer of resist material and the maximum height of the microstructures to be produced thereon,
b) stamping the thick layer of resist material by means of a shaping tool, which has microstructures, in such a manner that at least a portion of the microstructure end faces penetrates so far into the thick layer that the layer thickness of resist material is maintained over this portion of the microstructure end faces,
c) separating the shaping tool from the microstructured thick layer of resist material.

5. Method according to one of claims 1 to 4, characterised in that the layer of resist material on the side not to be provided or not provided with microstructures is connected to a base plate.

6. Method according to claims 5, characterised in that the base plate is formed from metal or ceramics or semiconductor material or plastics material.

## Revendications

1. Procédé de fabrication de microstructures à gradins avec des hauteurs différentes de structure par endroits, dans lequel
a) on irradie une couche d'un résiste positif sensible aux rayons X en utilisant un masque avec des rayons X,
b) on enlève les zones irradiées à l'aide d'un révélateur,
caractérisé en ce que
c) la couche de résiste est pourvue de microstructures avant de réaliser les étapes a) et b) sur sa face tournée vers le rayonnement

2. Procédé selon la revendication 1,
caractérisé en ce que
les microstructures sont produites sur la couche de résiste par :
a) Remplissage des espaces compris entre les microstructures d'un outil de formage microstructuré avec une matière fluide durcissable,
b) Compression de l'outil de formage rempli de cette manière sur la couche de résiste de telle sorte que la matière plastique vienne en contact entre les microstructures de l'outil de formage avec la couche de résiste,
c) Durcissement de la matière plastique dans l'outil de formage en produisant une liaison solidaire entre la matière plastique et la couche de résiste,
d) Séparation de l'outil de formage d'avec la matière plastique microstructurée et la couche de résiste

3. Procédé selon la revendication 1, caractérisé en ce que les microstructures sont produites sur la couche de résiste par :
a) Fabrication d'une liaison solidaire d'une couche d'une matière plastique matriçable avec la couche de résiste,
b) Matriçage de la couche de matière plastique à l'aide d'un outil de formage présentant une microstructure d'une manière telle qu'au moins une partie des faces frontales de la microstructure de l'outil de formage libère la couche de résiste,
c) Séparation de l'outil de formage d'avec la couche microstructurée de matière plastique et la couche de résiste.

4. Procédé selon la revendication 1,
caractérisé en ce que
les microstructures sont produites sur la couche de résiste par
a) Fabrication d'une couche épaisse, matriçable de résiste, dont l'épaisseur correspond au moins à la somme de la hauteur de la couche de résiste et de la hauteur maximale des microstructures à produire dessus,
b) Matriçage de la couche épaisse du résiste à l'aide d'un outil de formage présentant une microstructure, d'une manière telle qu'au moins une partie des faces frontales de la microstructure pénètre assez loin dans la couche épaisse pour que sur cette partie des surfaces frontales de la microstructure l'épaisseur de la couche de résiste est conservée,
c) Séparation de l'outil de formage d'avec la couche épaisse microstructurée du résiste.

5. Procédé selon l'une des revendications 1 à 4,
caractérisé en ce que
la couche du résiste est reliée à une plaque de base par le côté qui n'est pas à pourvoir de microstructures ou qui n'est pas pourvu de microstructures.

6. Procédé selon la revendication 5,
caractérisé en ce que
la plaque de base est en métal ou en céramique ou en une matière de semi-conducteur ou en matière plastique.
